# EUROPÄISCHE PATENTANMELDUNG

(11) **EP 0 982 768 A1**
(43) Veröffentlichungstag der Anmeldung: **01.03.2000**
(21) Anmeldenummer: 99810633.0
(22) Anmeldetag: 14.07.1999
(51) Int. Cl.: H01L 21/329, H01L 21/265, H01L 29/32, H01L 21/322

(54) **Verfahren zur Einstellung der Trägerlebensdauer in einem Halbleiterbauelement**

(30) Priorität: 21.08.1998 DE 19837944
(71) Anmelder: Asea Brown Boveri AG, 5401 Baden (CH)
(72) Erfinder: Galster, Norbert, 5102 Rupperswil (CH); Linder, Stefan, 4800 Zofingen (CH)
(74) Vertreter: Clerc, Natalia

(57) **Zusammenfassung**

In einem Verfahren zur Fertigung eines Halbleiterbauelementes, insbesondere einer Halbleiterdiode, wird ein Halbleitersubstrat (1) mit Metallschichten (3,4) zur Bildung von Elektrodenanschlüsse und einer Passivierung (2) versehen und einer Partikelbestrahlung (P) zur Einstellung der Trägerlebensdauer ausgesetzt. Dabei wird mindestens bestrahlungsseitig Metallschicht (3) und Passivierung (2) erst nach der Partikelbestrahlung (P) aufgebracht werden. Dadurch wird im Halbleitersubstrat (1) eine stufenlose Defektstellenzone (5) erhalten, welche unerwünschte Randeffekte ausschliesst.

## Beschreibung

### TECHNISCHES GEBIET

Die vorliegende Erfindung bezieht sich auf das Gebiet der Leistungselektronik, insbesondere der Halbleiterdioden. Sie betrifft ein Verfahren zur Fertigung eines Halbleiterbauelementes gemäss Oberbegriff des Patentanspruches 1 sowie ein Halbleiterbauelement gemäss Oberbegriff des Patentanspruches 5.

### STAND DER TECHNIK

Eine wichtige Grösse für die Wirkungsweise eines Halbleiterbauelementes ist seine axiale Trägerlebensdauer. Diese soll einerseits möglichst gross sein, um Durchlassverluste gering zu halten, jedoch soll sie auch möglichst klein sein, um eine schnelle Sperrfähigkeit zu erhalten. Es ist deshalb notwendig, für jedes Halbleiterbauelement ein optimales Mittelmass seiner Trägerlebensdauer zu finden. Um dies zu erreichen, werden Halbleiterbauelemente mit einer oder mehreren Defektstellenzonen oder Rekombinationszonen versehen, mittels welcher die Trägerlebensdauer gezielt einstellbar ist.

Die Erzeugung von Fehlstellen und somit die Einstellung der axialen Trägerlebensdauer an Halbleiter-Leistungsbauelementen lässt sich grundsätzlich auf drei Arten erzielen: durch Bestrahlung mit Elektronen, durch Dotierung mit Schwermetallen, insbesondere mit Platin oder Gold, oder durch Partikelbestrahlung mit energiereichen, schweren Teilchen, insbesondere mit Wasserstoff- oder Heliumkernen.

Die Bestrahlung mit Elektronen hat den Nachteil, dass das Halbleitersubstrat im gesamten Volumen mit Fehlstellen versehen wird, was keinen idealen Kompromiss zwischen Durchlassverhalten und Abschaltverhalten des Halbleiterbauelementes zulässt. Mittels Dotierung mit Schwermetallen lässt sich zwar erreichen, dass Fehlstellen lediglich in einer vorbestimmten Zone des Substrates erzeugt werden. Dieses Verfahren ist jedoch aufwendig und teuer.

Eine mittlerweile etablierte Technologie, welche eine gezielte Einstellung der Trägerlebensdauer erlaubt, ist die Partikelbestrahlung mit energiereichen, schweren Teilchen, wobei meistens Protonen oder Heliumkerne eingesetzt werden. Ein derartiger Partikelstrahl wird auf eine Oberfläche des Halbleitersubstrates gerichtet, so dass die Teilchen in das Substrat eindringen und dort Defektstellen erzeugen. Die Eindringtiefe der Teilchen hängt dabei von deren Energie und der Materialbeschaffenheit der zu durchdringenden Masse ab. Durch Wahl der Teilchenenergie ist es theoretisch möglich, die Eindringtiefe vorauszubestimmen und somit die Lage der Defektstellenzone genau einzustellen. Da Halbleiterbauelemente jedoch im allgemeinen nicht homogen aufgebaut sind, werden die einzelnen Teilchen unterschiedlichen Bedingungen ausgesetzt.

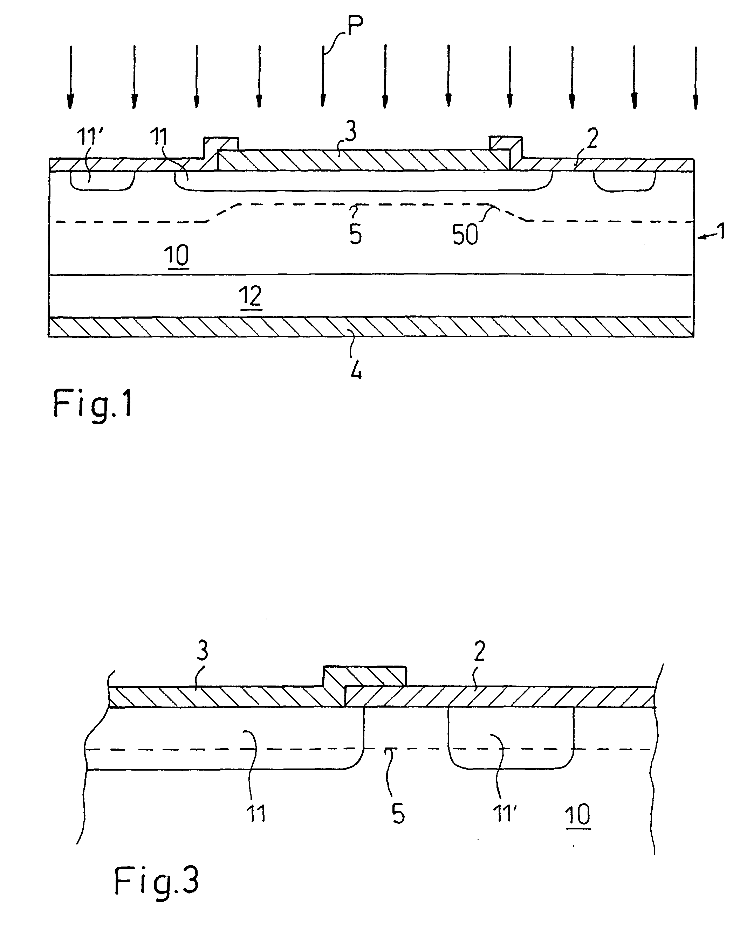

Dieses Problem stellt sich vorallem im Falle einer Halbleiterdiode. Eine derartige Diode ist in Figur 1 dargestellt. Auf zwei gegenüberliegenden Oberflächen eines Halbleitersubstrats 1 sind Metallschichten vorhanden, welche einen Anoden- 3 und einen Kathodenanschluss 4 bilden. Der Anodenanschluss 3 ist dabei von einer Passivierung 2 umgeben, um Randeffekte, insbesondere geladene Grenzflächenzustände, zu vermeiden. Da sich die Defektstellenzone benachbart zur Anode 11 befinden soll, muss anodenseitig bestrahlt werden. Wie in Figur 1 ersichtlich ist, durchdringt deshalb ein entsprechender Partikelstrahl P die Metallschicht 3 beziehungsweise die Passivierung 2, um in das Substrat 1 zu gelangen. Dabei üben Metallschicht und Passivierung unterschiedliche Bremswirkungen auf die Teilchen des Partikelstrahls aus, so dass die Teilchen nicht in gleicher Tiefe zur Ruhe kommen. Vielmehr wird eine Defektstellenzone 5 erhalten, welche nicht parallel zur anodenseitigen Oberfläche verläuft, sondern zum Rand hin eine Stufe 50 aufweist. Diese ungleichmässige Eindringtiefe der Teilchen und die daraus entstehende gestufte Defektstellenzone beeinträchtigt jedoch die Funktionsfähigkeit der Diode. Da der Rand der kritischste Bereich der Diode ist, wirkt sich diese Unzulänglichkeit umso stärker aus.

Ein weiterer Nachteil ist, dass der Partikelstrahl beim Durchdringen der Passivierung auch in diesem Bereich Defektstellen erzeugt, insbesondere werden kovalente Bindungen gebrochen. Dadurch entstehen sowohl in der Passivierung wie auch an der Grenzfläche zum Halbleiter Ladungszustände, welche die maximale Sperrfähigkeit der Diode verringern.

### DARSTELLUNG DER ERFINDUNG

Es ist deshalb Aufgabe der vorliegenden Erfindung, ein Verfahren zur Fertigung eines Halbleiterbauelementes und ein Halbleiterbauelement der eingangs genannten Art zu schaffen, welche die obengenannten Nachteile beheben.

Diese Aufgabe löst ein Verfahren mit den Merkmalen des Patentanspruches 1 sowie ein Halbleiterbauelement mit den Merkmalen des Patentanspruches 5.
Weitere vorteilhafte Varianten des Verfahrens und vorteilhafte Ausgestaltungsformen gehen aus den abhängigen Patentansprüchen hervor.

Erfindungsgemäss wird im Fertigungsprozess des Halbleiterbauelementes die Partikelbestrahlung vor der Aufbringung der Metallschicht und der Passivierung durchgeführt. Alle Teilchen der Partikelbestrahlung finden deshalb dieselben Bedingungen vor, so dass sie gleich tief in das Halbleitersubstrat eindringen.

Das erfindungsgemässe Verfahren erlaubt die Fertigung eines Halbleiterbauelementes mit einer Defektstellenzone, welche auch in den Randbereichen stufenlos ist. Dabei hängt die Lage der für die Einstellung der Trägerlebensdauer wichtigen Defektstellen nicht von der Dicke und Beschaffenheit der Passivierung und/oder Metallisierung ab. Zudem ist die Passivierung, da sie erst nach der Partikelbestrahlung aufgebracht wird, vor einer Beschädigung geschützt.

Die Wahl von geeigneten Materialien und geeigneter Depositionstechniken für die Passivierung und Metallisierung ermöglicht eine Aufbringung bei Temperaturen von weniger als 350°C. Dadurch wird gewährleistet, dass durch die Partikelbestrahlung erzeugte Defektstellen der Defektstellenzone nicht wieder rückgängig gemacht werden.

Das erfindungsgemässe Verfahren eignet sich zur Fertigung aller Halbleiterbauelementen, bei welchen die Trägerlebensdauer mit hoher Genauigkeit eingestellt werden muss. Es eignet sich insbesondere zur Fertigung von Dioden, welche anodenseitig zu bestrahlen sind.

### KURZE ERLÄUTERUNG DER FIGUREN

Anhand den beiliegenden, nicht masstabsgetreuen Zeichnungen wird das erfindungsgemässe Verfahren näher erläutert. Es zeigen
- Figur 1: einen Querschnitt durch ein Halbleiterbauelement, welches nach einem Verfahren gemäss dem Stand der Technik hergestellt ist;
- Figur 2a: ein Halbleiterbauelement in einem ersten Herstellungsschritt des erfindungsgemässen Verfahrens;
- Figur 2b: das Halbleiterbauelement gemäss Figur 2a in einem zweiten Herstellungsschritt des erfindungsgemässen Verfahrens und
- Figur 3: einen Querschnitt durch einen Teil eines Halbleiterbauelementes, hergestellt nach dem erfindungsgemässen Verfahren.

### WEGE ZUR AUSFÜHRUNG DER ERFINDUNG

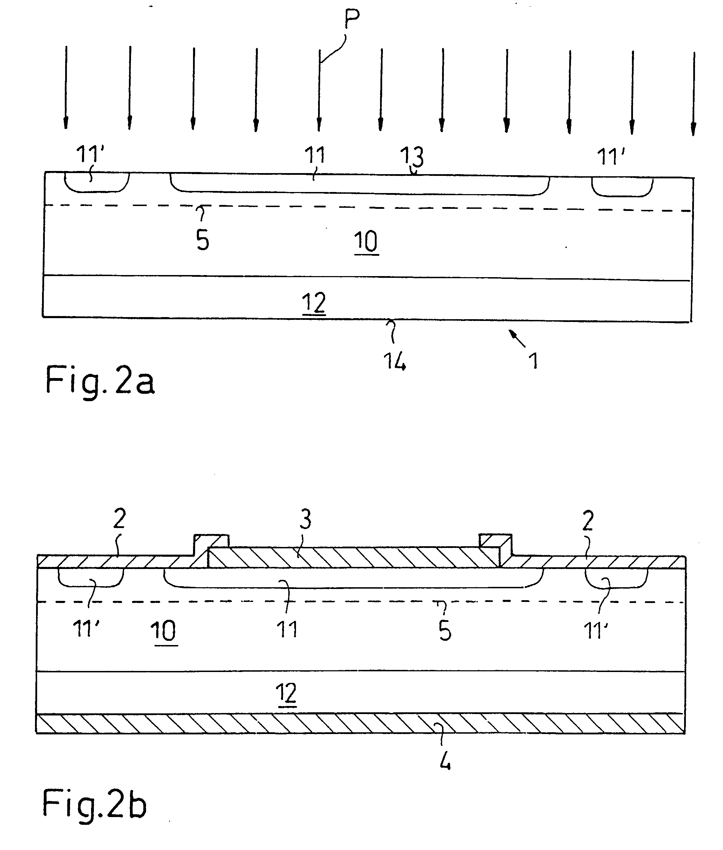

Die Figuren 2a und 2b zeigen zwei Herstellungsschritte einer Halbleiterdiode nach dem erfindungsgemässen Verfahren. In Figur 2a ist das Grundelement einer Halbleiterdiode, nämlich das Halbleitersubstrat 1, dargestellt. Es besteht vorzugsweise aus Silizium (Si), Gallium-Arsenid (GaAs), Siliziumkarbid (SiC), Germanium (Ge) oder Silizium-Germanium (SiGe). Es weist zwei parallele Oberflächen auf, eine anodenseitige 13 und eine kathodenseitige 14. Zwischen den Oberflächen 13,14 sind im wesentlichen drei Zonen angeordnet: eine schwach dotierte n⁻-Zone 10, eine stark dotierte p-Zone 11 und eine stark dotierte n⁺-Zone 12. Die n⁻-Zone 10 befindet sich zwischen der p- und der n⁺-Zone, wobei sie die p-Zone umgibt und sich somit bis zur anodenseitigen Oberfläche 13 des Substrates 1 erstreckt. Im Randbereich des Substrates 1 ist eine zweite p-Zone in Form eines Feldringes 11' vorhanden. Es können jedoch auch andere geläufige Randabschlüsse wie beispielsweise VLD (Variation of lateral doping) vorhanden sein. Diese Zonen wurden mittels bekannter Dotierverfahren geschaffen, welche hier nicht eingehender beschrieben werden.

Dieses in dotierte Zonen unterteilte Halbleitersubstrat 1 wird nun in einem ersten Verfahrensschritt einem Partikelstrahl P ausgesetzt, welcher p-zonenseitig, das heisst anodenseitig, auf das Substrat 1 einwirkt. Vorzugsweise werden hierfür Heliumkerne eingesetzt, es lassen sich jedoch auch Protonen oder andere energiereiche, schwere Teilchen verwenden. Dabei wird die gesamte anodenseitige Oberfläche 13 möglichst gleichmässig bestrahlt. Im Halbleitersubstrat 1 entsteht eine Defektstellenzone 5, welche stufenlos und mindestens annähernd parallel zur anodenseitigen Oberfläche 13 des Substrates 1 verläuft. Lage und Breite der Defektstellenzone 5 innerhalb des Substrates 1 hängen im wesentlichen von der Energie des Partikelstrahls ab und lassen sich somit sehr genau einstellen, wobei die optimale Lage auf mehreren Faktoren beruht. Je nach Art und Verwendungszweck der Diode mag es, wie in Figur 2a dargestellt, sinnvoll sein, die Defektstellenzone so zu legen, dass sie zwar benachbart zur anodenseitigen Oberfläche 13 liegt, sich jedoch ausschliesslich in der n⁻-Zone 10 befindet. In einem anderen Fall mag es zu optimalen Ergebnissen führen, wenn die Defektstellenzone 5 die p-Zone 11 durchläuft, wie dies in Figur 3 ersichtlich ist.

Nach der Partikelbestrahlung werden nun einzelne Schichten auf dem Substrat 1 deponiert. Das Ergebnis dieses Vorganges ist in Figur 2b dargestellt. Auf der anodenseitigen Oberfläche 13 des Substrates 1 wurde eine erste Metallschicht aufgebracht, welche die p-Zone 11 mindestens teilweise überdeckt. Diese Metallschicht bildet einen Anodenanschluss 3. Um diese Metallschicht herum wurde eine Passivierung 2 deponiert, welche auch die Randgebiete der Substratoberfläche bedeckt. Auf der gegenüberliegenden Seite, das heisst der kathodenseitigen Oberfläche 14 des Substrates 1 wurde eine zweite Metallschicht deponiert, welche sich über die gesamte Oberfläche erstreckt und einen Kathodenanschluss 4 bildet.

Die zwei Metallschichten weisen typischerweise eine Dicke von 3 - 20 µm auf. Sie werden bei einer Temperatur von weniger als 350°C aufgebracht, um die durch die Partikelbestrahlung gebildete Defektstellenzone mit ihren Defektstellen nicht rückgängig zu machen. Das Material für die Passivierung wird deshalb entsprechend gewählt, wobei vorzugsweise DLC (Diamond-like-Carbon), amorphes Silizium, dotierte oder undotierte Gläser oder Polyimide eingesetzt werden.

Die Reihenfolge des Aufbringens der Schichten hängt wiederum von verschiedenen Faktoren, unter anderem von den Materialbeschaffenheiten ab. Im hier dargestellten Beispiel wird zuerst die anodenseitige Metallschicht 3 und anschliessend die Passivierung 2 aufgebracht, wobei die Passivierung 2 die Metallschicht 3 teilweise überlappt. In Figur 3 ist dies gerade umgekehrt, wobei keinerlei Zusammenhang zwischen Reihenfolge von Passivierung und Metallschicht und der optimalen Lage der Defektstellenzone besteht.

Auch die kathodenseitige Metallschicht 4 lässt sich zu verschiedenen Zeitpunkten deponieren. In einer ersten Variante des Verfahrens wird sie nach der Partikelbestrahlung und vor, während oder nach der Deponierung der anodenseitigen Metallschicht 3 aufgebracht. In einer anderen Variante wird die kathodenseitige Metallschicht 4 jedoch bereits vor der Partikelbestrahlung deponiert und gesintert. Diese Lösung ist dann von Vorteil, wenn der Kontakt der kathodenseitigen Metallschicht zum Halbleitersubstrat nicht genügend gut ist und deshalb bei Aufbringung, insbesondere bei Sinterung, der Metallschicht eine Temperatur grösser als 350°C erfordert.

Dies kommt beispielsweise bei niedrigen n-Dotierungen der Kathode vor.

### BEZEICHNUNGSLISTE

- 1: Halbleitersubstrat
- 10: n⁻-Zone
- 11: p-Zone
- 11': Feldring
- 12: n⁺-Zone
- 13: anodenseitige Oberfläche
- 14: kathodenseitige Oberfläche
- 2: Passivierung
- 3: Anodenanschluss
- 4: Kathodenanschluss
- 5: Defektstellenzone
- 50: Stufe
- P: Partikelstrahl

## Patentansprüche

1. Verfahren zur Fertigung eines Halbleiterbauelementes, insbesondere einer Halbleiterdiode, aus einem Halbleitersubstrat (1), welches mit Metallschichten (3,4) zur Bildung von Elektrodenanschlüsse und einer Passivierung (2) versehen wird und welches einer Partikelbestrahlung (P) zur Einstellung der Trägerlebensdauer ausgesetzt wird,
dadurch gekennzeichnet, dass
mindestens bestrahlungsseitig Metallschicht (3) und Passivierung (2) erst nach der Partikelbestrahlung (P) aufgebracht werden.

2. Verfahren nach Anspruch 1, dadurch gekennzeichnet, dass vor der Partikelbestrahlung (P) des Halbleitersubstrates (1) eine nicht bestrahlte Oberfläche (14) des Halbleitersubstrates (1) mit einer Metallschicht (4) versehen wird.

3. Verfahren nach Anspruch 1, dadurch gekennzeichnet, dass alle Metallschichten (3,4) nach erfolgter Partikelbestrahlung (P) auf das Halbleitersubstrat (1) aufgebracht werden.

4. Verfahren nach Anspruch 1, dadurch gekennzeichnet, dass die Passivierung (2) bei einer Temperatur von kleiner als 350°C deponiert wird.

5. Halbleiterbauelement, hergestellt nach dem Verfahren gemäss Anspruch 1, mit einem Halbleitersubstrat (1), welches mit Metallschichten (3,4) zur Bildung von Elektrodenanschlüssen und einer Passivierung (2) versehen ist und welches eine durch Partikelbestrahlung (P) erzeugte Defektstellenzone (5) zur Einstellung der Trägerlebensdauer aufweist,
dadurch gekennzeichnet, dass
die Defektstellenzone (5) stufenlos und mindestens annähernd parallel zu einer Oberfläche (13,14) des Halbleitersubstrates (1) verläuft.

6. Halbleiterbauelement nach Anspruch 5, dadurch gekennzeichnet, dass die Defektstellenzone (5) mindestens annähernd parallel zur anodenseitigen Oberfläche (13) verläuft.

7. Halbleiterbauelement nach Anspruch 5, dadurch gekennzeichnet, dass die Passivierung (2) aus DLC (Diamond-like Carbon), amorphem Silizium, einem Glas oder einem Polyimid besteht.

8. Halbleiterbauelement nach Anspruch 5, dadurch gekennzeichnet, dass sich die Defektstellenzone (5) benachbart zu einer anodenseitigen Oberfläche (13) des Halbleitersubstrates (1) befindet.

9. Halbleiterbauelement nach Anspruch 5, dadurch gekennzeichnet, dass es eine Diode ist.
